# EUROPEAN PATENT APPLICATION

(11) **EP 4 534 213 A2**
(43) Date of publication of application: **09.04.2025**
(21) Application number: 24382648.4
(22) Date of filing: 14.06.2024
(51) Int. Cl.: B05D 7/16, C23C 14/02, C23C 14/58, C25F 3/22, C25F 3/24, C23C 14/00, C23C 18/16, C25D 5/00, C25F 3/20, C23F 3/02, C23F 3/04, A45D 34/00

(54) **DECORATIVE, PROTECTIVE AND/OR FUNCTIONAL PROCESS OF A METAL PART FOR PERFUMARY AND COSMETIC CONTAINERS OR OTHER USES, AND METAL PART WITH DECORATIVE AND/OR FUNCTIONAL FINISH FOR PERFUMERY AND COSMETIC CONTAINERS OR OTHER USES**

(30) Priority: 20.07.2023 ES 202331348 U
(71) Applicant: Flosty Pack Republic, S.L., 08570 Torelló Barcelona (ES)
(72) Inventor: SALA PUJOL, Albert, 08570 TORELLÓ (ES); VILARÓ ALBOQUERS, Guillem, 08570 TORELLÓ (ES); CORREIA DE OLIVEIRA SANTOS, Susana Isabel, 08570 TORELLÓ (ES); COSTA SUBIRÀ, Irene, 08570 TORELLÓ (ES)
(74) Representative: Espiell Gomez, Ignacio

(57) **Abstract**

The present invention relates to a decorative, protective and/or functional process of a metal part for perfumery and cosmetic containers or other uses comprising a polishing and/or brightening step of at least a portion of the external surface (1a) of the metal part (1), and a step of applying a top coat layer (3) on at least a portion of the external surface (1a) of the metal part (1) to maintain the surface finish of the polished part and, optionally, give colour, without requiring an anodising step. The polishing and/or brightening step comprises a mechanical, chemical or electrochemical process of fine metal coating. Preferably, the decorative, protective and/or functional process comprises a degreasing and/or cleaning step prior to the incorporation of the top coat layer (3) and a drying step of the top coat layer (3). Preferably, the aluminium metal part (1) comprises a PCR and/or PIR recycled aluminium content of more than 8%.

## Description

### OBJECT OF THE INVENTION

The invention, as expressed in the statement of this specification, relates to a decorative, protective and/or functional process of a metal part for perfumery and cosmetic containers or other uses that is applicable as a decorative and/or functional element, as well as to the metal part resulting from the process with a decorative and/or functional finish for perfumery and cosmetic containers or other uses which provide advantages and features, which are described in detail below.

The object of the present invention lies in a decorative, protective and/or functional process of a part made of metal, such as aluminium, steel or stainless steel and other metallic materials, which, intended to serve as a container or as a decorative element, protection and/or functional element of a container or other cosmetic article, for example as a stopper, collar or lid, but without ruling out other uses, preferably obtained by stamping, and also preferably with a shiny mirror effect finish.

Specifically, the decorative, protective and/or functional process of a metal part object of the invention has the particularity of maintaining the surface finish of the polished and polished metal part, without the need for a usual anodising process to give it the shiny mirror effect finish that is currently performed in this type of parts.

Furthermore, the decorative, protective and/or functional process of a metal part object of the invention allows to create shine, and maintain the shine, in metals that usually do not shine after an anodising process, such as aluminium with a high percentage of recycled aluminium (Post Consumer Recycled (PCR) and Post Industrial Recycled (PIR)) or machined, injected or extruded aluminium.

### FIELD OF APPLICATION OF THE INVENTION

The field of application of the present invention falls within the sector of the industry dedicated to the manufacture of perfumery and cosmetic containers, perfumery and similar, focussing particularly on the field of metal parts, both decorative and functional, which usually includes this type of containers. The present invention can not only be applied to container parts but to complete products such as a metal container (aerosol container or refillable container).

### BACKGROUND OF THE INVENTION

As is known, containers and other packaging articles of cosmetic products such as cases and similar, as well as from other sectors, but especially in the field of cosmetics and perfumery, usually include elements, such as stoppers, collars, lids and others, made from metal parts, often made of aluminium, and commonly with a shiny mirror effect finish. In some cases, even the entire container is made of metal, such as an aerosol container or a refillable container.

This is normally due to the fact that said finish provides a visual appeal that helps capture the attention of consumers, as it creates a sensation of wealth and luxury, which causes visual effects in the form of reflections that attract attention and, eventually, which can ensure special protection of the product against light or other external factors.

The problem is that, to obtain this type of parts, which are usually manufactured through a stamping, machining, extrusion or injection process, it usually involves a surface treatment process, such as an anodising process to give it the shiny finish being sought.

As is known, anodising is an electrochemical process that generally involves the consumption of water and energy but which, in addition to aesthetic properties, provides resistance to corrosion and increases the hardness of the part.

Likewise, anodising is not a process capable of making all metals shine, and particularly those with a high content of recycled aluminium (PCR and PIR). In the anodising process these parts become matte and do not shine.

The objective of the present invention is, therefore, to provide the market with a new type of metal part, preferably produced by stamping and also preferably with a shiny mirror effect finish, which, offering the same aesthetic effect benefits of a mirror finish and sufficient strength for the function for which it is intended, avoids the anodising process.

The present invention has special relevance when the metal part is manufactured with less pure aluminium alloys (aluminium with a high content of recycled aluminium PCR and/or PIR), with new materials (such as steel and stainless steel), or when the part has been formed by machining, injection or extrusion, it is not possible to obtain a mirror gloss finish through standard anodising and it is necessary to carry out a specific improved polishing process so that, after the protection step, the same degree of mirror shine that the sector demands is achieved, as that which results from standard anodising.

Moreover, and as a reference to the current state of the art, it should be noted that, at least on the part of the applicant, the existence of any other metal part or metal container that presents technical, structural and constitutive features equal or similar to those of that which is being claimed herein is unknown.

### DESCRIPTION OF THE INVENTION

Decorative, protective and/or functional process of a metal part or container, such as aluminium, steel or stainless steel which, intended to serve as a container or as a decorative element and/or functional element of a container or another cosmetic article that the invention proposes is configured as an optimal solution to the aforementioned objectives, with the characterising details that make it possible and that distinguish it conveniently included in the final claims that accompany the present description.

Specifically, what the invention proposes, as noted above, is a decorative, protective and/or functional process of a part made of metal, such as aluminium, steel or stainless steel, which intended to serve as a container or as a decorative element and/or functional element of a container or other cosmetic article, for example as a stopper, as a collar, as a lid, but without ruling out other uses, preferably being a part obtained by stamping, and also being preferably a part of the type that has a shiny mirror effect finish, it is distinguished by the fact that the shiny finish of the substrate is obtained through a polishing and/or brightening step after which a top coat layer is applied, such as a lacquer.

A polishing process is understood as a process through which the surface of a part is smoothed, the roughness decreases and reduces and/or removes marks, chafing, scratches and small defects generated during the part forming process.

A brightening process is understood as a process through which there is a reduction in the roughness of the surface of the part to produce and/or highlight the shine, in addition to generating a gloss and a uniformity in the surface finish.

Due to the above, the part resulting from the decorative, protective and/or functional process object of the invention is a part made of aluminium or other metal with a mirror effect finish where the anodising that is normally applied to said parts to give them the mirror effect finish with protection has not been applied.

The metal part is, in some embodiments, made of aluminium (including aluminium of different alloys, various degrees of purity and consisting of a large percentage, or entirely, of recycled material), steel, stainless steel or copper, although other materials are not ruled out.

In some embodiments, the metal part is virgin aluminium. Virgin aluminium is a high-purity alloy that is commonly used in the cosmetic product packaging sector due to its high sheen after anodising and the associated variety of colours. However, the electropolishing and anodising process required to produce a mirror effect has some drawbacks or limitations.

In other embodiments, the metal part comprises PCR and/or PIR aluminium, i.e., recycled aluminium (Post Consumer Recycled (PCR) and Post Industrial Recycled (PIR)). For example, the metal part may contain up to 100% aluminium from PCR and/or PIR.

When a part made of aluminium with a content of more than 8% PCR and/or PIR aluminium is anodised, it loses its shine, i.e., a matte finish is produced. As the mirror effect is generally required in the luxury cosmetics sector, the use of PCR and/or PIR aluminium is not common in the luxury cosmetics sector as it cannot offer the required mirror effect.

Currently in the luxury cosmetics sector there is a barrier to the use of recycled metals, such as PCR and/or PIR aluminium, since, above 8% PCR and/or PIR composition, the material does not shine when it is anodised. A matte finish is obtained that is not attractive for the luxury cosmetics and perfumery sector.

However, the use of recycled materials (PCR and/or PIR) in the manufacture of metal parts implies a significant reduction in polluting emissions, such as CO2. For example, CO2 emissions for manufacturing aluminium with 20% PCR and/or PIR aluminium can be 78.9% lower than CO2 emissions for manufacturing virgin aluminium.

As the market trend is to use increasingly more recycled materials and companies are beginning to define their sustainability plans that include the greater use of recycled materials, it would be interesting to have a decorative, protective and/or functional process for metal parts that would show the mirror effect after the process.

The metal part (whether made of virgin material or recycled material) can be formed using various techniques.

The metal part in some embodiments is formed by machining. In a more specific embodiment, the machined parts are subsequently ground using a high quality grinding process (Roughness less than 0.8 microns). It is known that machined aluminium parts considerably lose their shine when anodised. The lack of shine, i.e., the matte finish, is not attractive for the luxury cosmetic and perfumery container sector. However, machined metal parts offer a greater feeling of luxury as they are heavier than metal parts produced by other systems, such as moulding. It would be interesting to have a decorative, protective and/or functional process for machined metal parts that would show the mirror effect after the process. In this way, it would be possible to obtain machined metal parts with a mirror effect.

The metal part in some embodiments is formed by injection. Injected or die casting aluminium, both cast and normal injection, is difficult to polish to achieve a high surface shine. Typical polishing technologies where the objective is to remove burrs or excess material from the injection process, such as bulk vibration polishing with abrasives such as metal particles, porcelain fragments or nutshells, expose the porosity of the metal and are unlikely to achieve a smooth and shiny surface. This is true for many alloys such as L-2521 (AB-47100), L-2520 (AB-44100), or L-2631 (AB-46000). It would be interesting to have a decorative, protective and/or functional process for injected metal parts that would show the mirror effect after the process.

The metal part in some embodiments is formed by extrusion. As with machined aluminium, extruded aluminium loses shine when anodised and achieves a matte finish. It would be interesting to have a decorative, protective and/or functional process for extruded metal parts that would show the mirror effect after the process.

The metal part in some embodiments is formed by cold forging, i.e., using only pressure (without removing or adding any material or temperature). The resulting part does not offer a shiny surface with a mirror effect. It would be interesting to have a decorative, protective and/or functional process for metal parts formed by forging that would show the mirror effect after the process.

Until now, one of the most common ways to achieve a mirror effect finish on aluminium parts is through an anodising step. There are also other techniques for adding material to aluminium to achieve a mirror effect finish (PVD, metallisation, galvanisation).

The polishing of metal parts, such as aluminium, iron, copper, brass, zinc, steel or stainless steel, has until now been used to remove defects created during the forming of the part, to reduce excessive roughness or to achieve sharper edges: this contributes to making it possible to obtain the mirror effect after the chemical polishing step (which typically precedes the anodising step) and anodising the aluminium part.

The present invention proposes a polishing and/or brightening process that not only aims to remove defects, but also seeks to reduce roughness and increase the shine on the metal surface, producing a metal part with a mirror effect while maintaining its geometry as much as possible.

This mirror effect part can be directly protected by a top coat layer to maintain the surface finish of the polished part, without requiring an anodising step.

The process of polishing the metal part to obtain the mirror effect in aluminium with PCR and/or PIR percentage above 8%, machined aluminium, steel or other types of materials, the process of the invention provides for different techniques depending on the material and the shape of the part.

For example, it is possible to polish a metal part through a mechanical process in which discs made of materials such as cotton or flannel and polishing and brightening pastes with different compositions, preferably alumina-based, are used. Mechanical polishing achieves high sheen finishes, as well as more uniform finishes and therefore better surface quality.

Mechanical polishing is an efficient technology to remove different types of surface defects thanks to the different combinations of cloths/discs with polishing pastes applied to the part with appropriate inclinations and speeds.

In mechanical brightening, a subsequent step to mechanical polishing, it is important to define special protocols so that this shine is uniform throughout the part, to maintain a range of roughness within certain numbers and a range of reflectance that is also uniform - the reflectance is preferably from 50%.

Mechanical brightening produces a high sheen mirror effect finish that has, depending on the technique and protocols used, as well as a certain sensitivity to scratches and handling marks and resistance to oxidation.

The mechanical brightening process can be carried out manually or with automatic machines that adjust to the desired production level. The parameters of the mechanical polishing and brightening machine are also important to achieve the final result. After mechanical polishing the surface is homogeneous. Eventually, after polishing, a mechanical brightening process is carried out with the aim of making the smooth surface shine as much as possible.

It is also possible to brighten a metal part through a chemical or electrochemical process using an electrolyte. In the European Union there is a general trend in the industry to remove mechanical polishing from industrial processes that are, generally, low production and promote more industrial processes with high productive capacity. The mechanical polishing process can be replaced by chemical or electrochemical polishing and brightening. However, there are certain materials, such as recycled aluminium (generally with more than 20% PCR and/or PIR) that, when polished and brightened using a standard chemical or electrochemical process, become matte and the shine effect is not achieved.

It is sometimes difficult to achieve a high degree of shine with some materials using a standard mechanical polishing process. Furthermore, it is difficult to polish some parts with certain complex shapes, such as decorations or textures and the concave areas of the parts to be polished, using mechanical processes. Electrochemical polishing of this type of complex parts, for example, through the use of sulphuric acid and phosphoric acid, achieves a high sheen while removing mechanical polishing marks such as disc lines, shadows, metal defects.

In electrochemical polishing, the part is introduced into an electrolyte, preferably at a high temperature (above 60 °C) and with constant movement, and by applying current between the part to be polished and the electrolyte, an electrochemical reaction is produced that manages to reduce the roughness of the material by removing material from the peaks the surface of the surface resulting in a substrate with lower roughness and therefore smoother.

It is difficult to achieve, through standard mechanical or electrochemical polishing, a mirror effect finish on some parts made of certain metals or containing some specific shapes. Additionally, some decorations (deep textures and logos) and shapes may be difficult or impossible to polish and varnish for effective protection. Therefore, there is a need to identify technologies that allow a fine metal finish to deliver this uniformity and high sheen. This metal finish is intended to have an effect similar to that of anodising and provides strength and good adhesion.

In this sense, there are other methods to make aluminium parts shine, such as a thin metallic coating applied through a vacuum process, metallisation or electroplating.

The process of thin metal coating of an aluminium metal part using a vacuum process (PVD) allows the part to be coated with a protective and decorative layer. For example, it is possible to coat an aluminium part using PVD with Al 5657 and Al 6082 alloys to achieve a thin metallic layer that maintains the surface with low roughness and a metallic finish similar to the mirror effect. PVD allows a wide variety of colours and correct adhesion with aluminium and other metals.

The metallisation process is generally used to treat non-conductive materials and only as a coating. However, the metallisation process is also applied to metal parts. For example, it is common to treat zinc parts by metallisation. Metallisation allows producing a variety of colours depending on the final process. Metallisation allows the adherence of aluminium and other metals.

The electroplating process is interesting for treating some metals, since this process provides extra thickness of the metal layer and provides physical resistance while offering a good coating of the entire surface, even when it is textured.

Once the metal part has a shiny metal surface, preferably with a mirror effect, it tends not to be resistant to mechanical and chemical attacks. For this reason, it is interesting to apply a protective layer that maintains the shiny appearance of the surface of the part and preferably allows producing a colour similar to that obtained through an anodising process.

There are different coatings available depending on the requirements of the resulting part to be obtained.

In one embodiment, the step of applying a top coat layer comprises a varnishing (VA) process. The varnishing process deposits one or several layers of varnish on the surface of the metal part, protecting the metal surface while maintaining the appearance of the metal surface. The varnishing process allows producing a metal part with a colour similar to that which is obtained through an anodising process.

The varnishing process, in one embodiment, has at least two steps:
1) Priming step: Improves adherence and durability. Also for a smoother finish. It can be with or without colour.
2) Step of application of top coat: Transparent layer that acts as a protective barrier and provides mechanical and chemical strength.

In a specific embodiment, the process of applying a top coat layer after polishing and/or brightening comprises a phase of cleaning the part, a flaming phase, a primer application phase to improve adherence to the metal substrate and finally a phase of applying the top coat, such as a varnish or lacquer.

It is possible to use various types of coatings, such as lacquers and varnishes, in the step of applying a top coat layer taking into account the metal, the shape of the part, the existence of texturing or engravings and the customer's requirements. For example, there are lacquers or varnishes that can change the colour of the metal part. There are also lacquers or varnishes that can change the texture of the metal part. There are also lacquers and varnishes with different degrees of sustainability that comply with the different existing sustainability regulations.

In one embodiment, and especially when the top coat layer comprises a lacquer or varnish of the UV or PU type, such as a varnish based on polyurethane resins, it is interesting to carry out a drying step of the lacquer or varnish. In a more specific embodiment, the drying step is preferably carried out through the use of ultraviolet (UV) radiation and/or the use of infrared, which allows the varnish layer applied to the surface of the part to quickly dry and cure.

Summing up, the decorative, protective and/or functional process of a metal part for perfumery and cosmetic containers or other uses of the invention has the objective of avoiding the use of the traditional anodising system.

To this end, the decorative, protective and/or functional process of the part after its formation, especially when it is a part made of aluminium, preferably comprises a polishing and/or brightening phase of the aluminium, which can be mechanical, chemical or electrochemical in a way that achieves a high sheen finish, or mirror effect and a step of application of a top coat layer to maintain the surface finish of the polished part, without requiring an anodising step. Preferably, the top coat layer is a thin layer of transparent lacquer, with or without colour, achieving an appearance similar to anodising.

Optionally, the decorative, protective and/or functional process of the part comprises a degreasing and washing step to remove the possible existence of traces of fatty products applied during the steps of the manufacturing process.

The advantages of the decorative, protective and/or functional process of the metal part of the invention are multiple, especially highlighting its sustainability nature.

### DESCRIPTION OF THE DRAWINGS

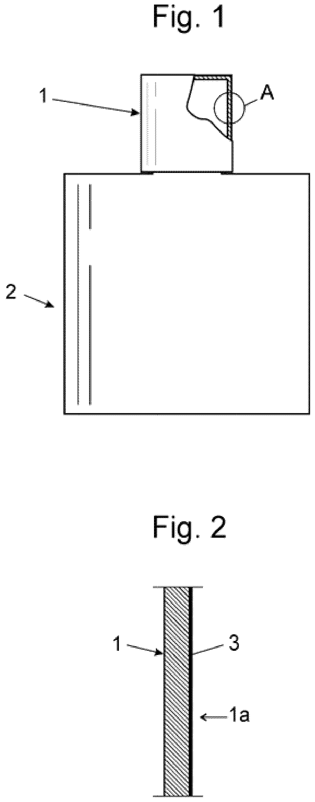

To complete the description provided herein, and for the purpose of helping to make the features of the invention more readily understandable, this description is accompanied by a set of drawings constituting an integral part of the same, which by way of illustration and not limitation represents the following:
Figure number 1 shows a schematic elevation view of an exemplary embodiment of a container with an exemplary embodiment of the metal part that is the object of the invention, specifically a stopper, which has been partially shown in cross-section; and
Figure number 2 shows an enlarged view of detail A indicated in Figure 1 and which schematically shows a representation of the configuration of the part of the invention, especially the top coat layer, such as a layer of lacquer, which it comprises to protect the mirror effect finish obtained by the polishing step.

### PREFERRED EMBODIMENT OF THE INVENTION

In view of the aforementioned figures, and in accordance with the numbering adopted, an example of a non-limiting embodiment of the decorative, protective and/or functional process of a metal part for perfumery and cosmetic containers or other uses can be observed therein, as well as the metal part with a decorative and/or functional finish for perfumery and cosmetic containers or other uses of the invention resulting from the process.

The decorative, protective and/or functional process of a metal part for perfumery and cosmetic containers or other uses that is the object of the invention comprises:
- a polishing and/or brightening step of at least a portion of the external surface (1a) of the metal part (1), and
- a step of applying a top coat layer (3) on at least a portion of the external surface (1a) of the metal part (1) to maintain the surface finish of the polished part, without requiring an anodising step.

The metal part (1) for perfumery and cosmetic containers or other uses is, in some embodiments, a decorative and/or functional element, such as for example a stopper (figure 1), a collar or a lid, of a cosmetics, perfumery and dermatology article (2) in the form of container, case.

The metal part (1) is, in some embodiments, made of aluminium (including aluminium of different alloys, various degrees of purity, including recycled material), steel, stainless steel or copper, although other materials are not ruled out.

In some embodiments, the decorative, protective and/or functional process comprises a degreasing and/or cleaning step prior to incorporating the top coat layer (3).

In some embodiments, the decorative, protective and/or functional process comprises a drying step with ultraviolet (UV) radiation and/or infrared drying of the top coat layer (3).

In some embodiments, the decorative and/or functional process, the top coat layer (3) that the part (1) incorporates on the external surface (1a) thereof is a layer of varnish or Physical Vapour Deposition (PVD).

In a more specific embodiment, the top coat layer (3) that the part (1) incorporates on the external surface (1a) thereof is a layer of varnish made from polyurethane resins.

It is also the object of the invention the metal part (1) obtained through the decorative, protective and/or functional process described above. In other words, a metal part with a decorative and/or functional finish for perfumery and cosmetic containers or other uses that is applicable as a container or as a decorative and/or functional element, such as a stopper, a collar, a lid or another, of a cosmetic article (2) in the form of a container, case or other similar article, which after presenting a shiny finish, preferably a mirror effect, has had a top coat layer (3) applied, such as a lacquer, which covers, at least, the external surface (1a) of the metal part (1) and maintains the surface finish of the part, i.e., the shiny mirror effect finish without requiring an anodising step.

Optionally, the part (1) consists of a part (1) made of metal that is polished and/or degreased prior to the incorporation of the top lacquer layer (3).

Preferably, the top coat layer (3) that the part (1) incorporates on the external surface (1a) thereof is a layer of varnish or Physical Vapour Deposition (PVD).

Preferably, the top coat layer (3) that the part (1) incorporates on the external surface (1a) thereof is a layer of varnish obtained by drying with ultraviolet (UV) radiation and/or infrared drying.

Preferably, the top coat layer (3) that the part (1) incorporates on the external surface (1a) thereof is a layer of varnish made from polyurethane resins.

Having sufficiently described the nature of the present invention, as well as the ways in which it may be implemented, it is not considered necessary to elaborate on the explanation thereof in order for a person skilled in the art to understand the scope of the invention and the advantages derived therefrom.

## Claims

1. A decorative, protective and/or functional process of a metal part for perfumery and cosmetic containers or other uses that is applicable as a container or as a decorative and/or functional element, such as a stopper, a collar, a lid or other, of one (2) cosmetic article in the form of a container, case or other similar article **characterised in that** it comprises
• a polishing and/or brightening step of at least a portion of the external surface (1a) of the metal part (1), and
• a step of applying a top coat layer (3) on at least a portion of the external surface (1a) of the metal part (1) to maintain the surface finish of the polished part and, optionally, give colour, without requiring an anodising step.

2. The decorative, protective and/or functional process of a metal part for perfumery and cosmetic containers or other uses, according to claim 1, **characterised in that** the polishing and/or brightening step comprises a mechanical process in which discs of various materials and various polishing pastes are used.

3. The decorative, protective and/or functional process of a metal part for perfumery and cosmetic containers or other uses, according to claim 1, **characterised in that** the polishing and/or brightening step comprises a chemical or electrochemical process using an electrolyte to obtain a shiny mirror effect finish.

4. The decorative, protective and/or functional process of a metal part for perfumery and cosmetic containers or other uses, according to claim 1, **characterised in that** the polishing step comprises a fine metal coating process to obtain a shiny mirror effect finish.

5. The decorative, protective and/or functional process of a metal part for perfumery and cosmetic containers or other uses, according to claim 4, **characterised in that** the fine metal coating process comprises a vacuum process (PVD) to obtain a shiny mirror effect finish.

6. The decorative, protective and/or functional process of a metal part for perfumery and cosmetic containers or other uses, according to claim 4, **characterised in that** the fine metal coating process comprises a metallisation process to obtain a shiny mirror effect finish.

7. The decorative, protective and/or functional process of a metal part for perfumery and cosmetic containers or other uses, according to claim 4, **characterised in that** the fine metal coating process comprises an electroplating process to obtain a shiny mirror effect finish.

8. The decorative, protective and/or functional process of a metal part for perfumery and cosmetic containers or other uses, according to any of the preceding claims, **characterised in that** it comprises a degreasing and/or cleaning step prior to incorporating the top coat layer (3).

9. The decorative, protective and/or functional process of a metal part for perfumery and cosmetic containers or other uses, according to any of the preceding claims, **characterised in that** it comprises a drying step with ultraviolet (UV) radiation and/or infrared drying of the top coat layer (3).

10. The decorative, protective and/or functional process of a metal part for perfumery and cosmetic containers or other uses, according to any of the preceding claims, **characterised in that** the top coat layer (3) that the part (1) incorporates on the external surface (1a) thereof is a layer of varnish or Physical Vapour Deposition (PVD).

11. The decorative, protective and/or functional process of a metal part for perfumery and cosmetic containers or other uses, according to any of the preceding claims, according to claim 4, **characterised in that** the top coat layer (3) that the part (1) incorporates on the external surface (1a) thereof is a layer of varnish made from polyurethane resins.

12. A metal part with a decorative and/or functional finish for perfumery and cosmetic containers or other uses that is applicable as a decorative and/or functional element, such as a stopper, a collar, a lid or another, for a cosmetic article (2) in the form of a container, case or other similar article, is **characterised in that** it consists of a part (1) made of metal, preferably produced by stamping, machining, extrusion and/or injection and with a shiny mirror effect finish, which comprises a top coat layer (3), such as a lacquer, which covers, at least, the external surface (1a) of the metal part (1) and maintains the surface finish of the part, such as the shiny mirror effect finish.

13. The metal part with decorative and/or functional finish for perfumery and cosmetic containers or other uses, according to claim 12, **characterised in that** it consists of a part (1) made of metal polished and/or brightened subsequently degreased and/or cleaned prior to the incorporation of the top coat layer (3).

14. The metal part with decorative and/or functional finish for perfumery and cosmetic containers or other uses, according to any of claims 12-13, **characterised in that** it consists of a metal part (1) made of aluminium, steel, stainless steel or copper.

15. The metal part with decorative and/or functional finish for perfumery and cosmetic containers or other uses, according to any of claims 12-13, **characterised in that** it consists of a metal part (1) made of aluminium with a PCR and/or PIR recycled aluminium content of more than 8%.

16. The metal part with decorative and/or functional finish for perfumery and cosmetic containers or other uses, according to any of claims 12-15, **characterised in that** the top coat layer (3) that the part (1) incorporates on the external surface (1a) thereof is a layer of varnish or Physical Vapour Deposition (PVD).

17. The metal part with decorative and/or functional finish for perfumery and cosmetic containers or other uses, according to any of claim 16, **characterised in that** the top coat layer (3) that the part (1) incorporates on the external surface (1 a) thereof is a layer of varnish obtained by drying with ultraviolet (UV) radiation and/or infrared drying.

18. The metal part with decorative and/or functional finish for perfumery and cosmetic containers or other uses, according to claim 16, **characterised in that** the top coat layer (3) that the part (1) incorporates on the external surface (1a) thereof is a layer of varnish made from polyurethane resins.
